# EUROPEAN PATENT APPLICATION

(11) **EP 2 573 574 A1**
(43) Date of publication of application: **27.03.2013**
(21) Application number: 11007662.7
(22) Date of filing: 21.09.2011
(51) Int. Cl.: G01R 1/067, G01R 1/07, G01R 29/08

(54) **Handheld test probe assembly for non-contacting microwave measurements and method of using same**

(71) Applicant: EADS Deutschland GmbH, 85521 Ottobrunn (DE)
(72) Inventor: Keil, Tobias, 89423 Gundelfingen (DE); Riedle, Fanz, 87634 Obergünzburg (DE)
(74) Representative: Meel, Thomas

(57) **Abstract**

The invention relates to a handheld test probe assembly (TP) for non-contacting microwave measurements on a microwave transmission line under test (MLT), the test probe assembly (TP) comprising a microstrip line coupler (C) realized on a PCB board (B), with the ground (G) at the back side of the PCB board (B) being removed at an area of the test probe (TP) that in operation is located adjacent to the microwave transmission line under test (MLT). Also disclosed is the use of the handheld test probe assembly (TP) for the measurement on a microwave transmission line realized on a PCB board (B).

## Description

The invention relates to a handheld test probe assembly for non-contacting microwave measurements as well as a method of using such test probe.

The measurement of power on microstrip transmission lines plays a decisive role in the failure analysis of sophisticated RF circuits. Because state of the art measurement devices are not suitable for microstrip designs and these circuits can't be unstitched for test purposes, debugging independently from any fix measurement pads is not possible. Increasing complexity of microstrip based RF modules has led to an urgent need for efficient failure analysis and the development of new probing techniques. Recent researches on the use of a semirigid loop coupler [1] [2] [3] to measure power on microstrip lines revealed several limitations. These devices are limited in bandwidth due to the physical coupler parameters. By reason of the non-linear frequency response characteristics, measurements without the mathematic tools of a network analyser or a calibration table are not possible. Moreover, precise probing without the use of an X/Y-Table can't be performed accurately enough which results from measurement errors caused by positioning errors.

Since the beginning of the 1960's the thin version of the microstrip line became more and more popular and is nowadays one of the most commonly used microwave transmission lines for RF-Circuits and modules. In the MMIC (Monolithic Microwave Integrated Circuit) technology microstrip lines are also preferably used. For the failure analysis of these mass produced circuits so called on-wafer probes are used. Measurements can only be performed on certain fixed points of the wafer by means of coplanar waveguide (CPW) to microstrip (MS) transitions and inflexible prober apertures. Without these CPW-to-microstrip transitions on-wafer measurements cannot be performed and therefore troubleshooting is more complicated. Errors, like the complete breakdown of a device are easy to detect via sniffer probe, but these simple devices are not precise enough to find more complicated bugs where only a small divergence in the signal level is crucial for the function of a system.

It is the object of the invention to overcome these challenges, in particular to provide a RF test probe assembly that is easy to handle and that allows precise probing at broad bandwidths.

This object is achieved by the test probe assembly according to Claim 1. Advantageous embodiments of the invention as well as a method how to use the test probe assembly are the subject matter of further Claims.

The invention is explained in greater detail hereafter on the basis of drawings. In the figures:
- Figure 1: shows a block diagram of an exemplary embodiment of the test probe assembly according to the invention;
- Figure 2: shows one end section of the test probe assembly according to the invention that in operation is placed next to the microstrip transmission line under test;
- Figure 3: shows one example of a compensation network as part of the test probe assembly-according- to the invention;
- Figure 4: shows the measurement set up of a test probe according to the invention.

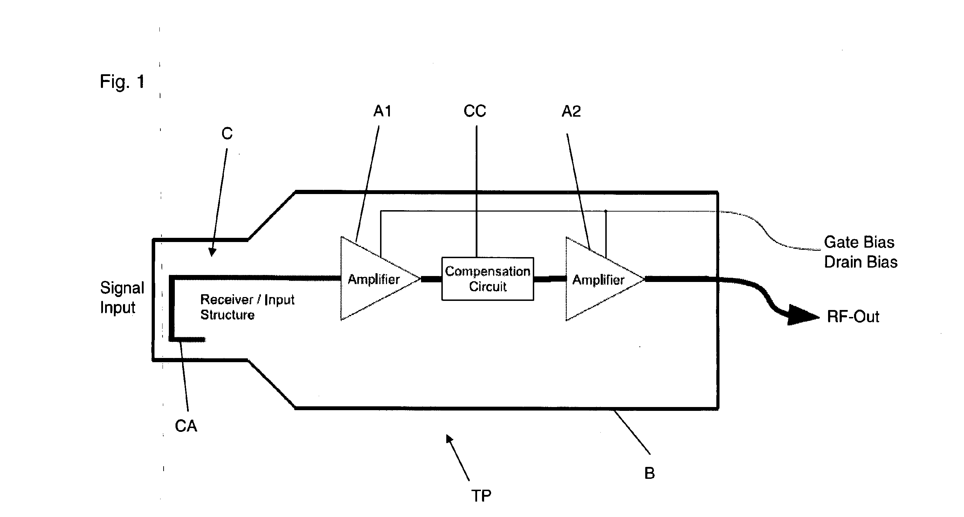

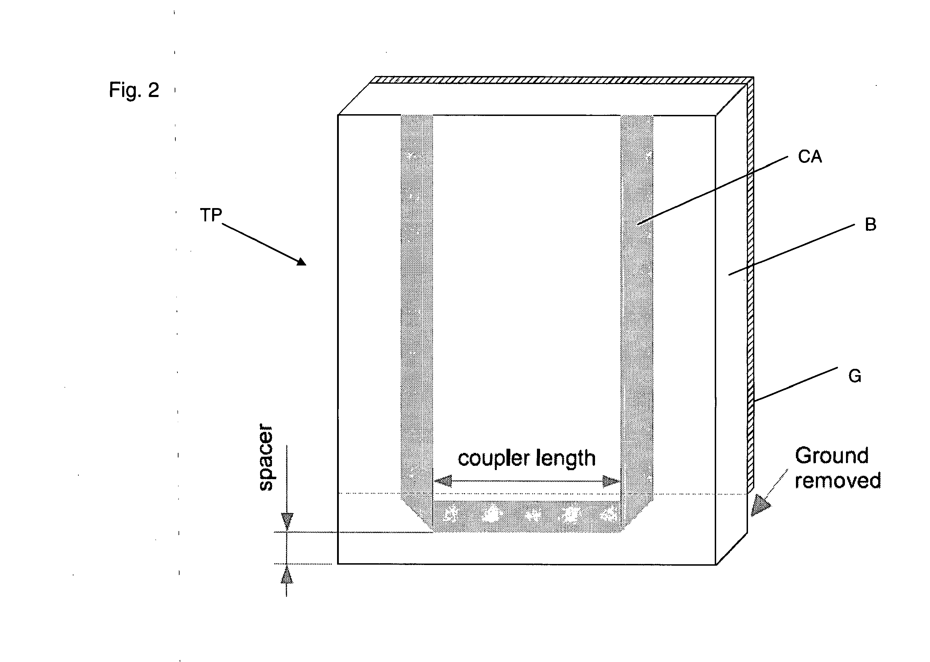

Figure 1 depicts the principle structure of the active RF test probe TP assembly according to the invention. The input signal is picked up by a passive microstrip line coupler C realised on a microstrip PCB board B. The signal is then fed into a compensation circuit CC that is sandwiched by two amplifier stages A1 and A2. For the power supply of the amplifiers A1,A2, the DC output of a measurement instrument (e.g. the network analyzer NA of Figure 2) is converted into the desired gate and drain voltages. All shown elements of the test probe, i.e. coupler C, amplifier A1,A2 and compensation circuit CC are realized on the same PCB board B. The design of the test probe TP shown in Figure 1 ensures high input impedance, linear transmission behaviour over the entire bandwidth and matching to the measurement equipment. The test probe assembly itself is mechanically stable and measurements do not affect the circuit under test.

The compensation network ensures a constant coupling value over the entire bandwidth. Together with the two amplifier stages, the coupled power is amplified to the measured power value on the circuit under test. Thus, the forward transmission gain of the active test probe in total is zero.

The described approach that allows non-contacting measurement has proven to be applicable over a wide frequency range with high accuracy. The coupler used separates forward and backward travelling waves and therefore indicates the precise power value on a microwave transmission line under test. The microwave transmission line under test in particular might be a microstrip line, a coplanar waveguide or a grounded coplanar waveguide.

In addition to a high directivity which enables to measure either the power to or from a load, this new approach also exhibits compatibility to most of the customary high frequency measurement equipments. With the integration of a compensation network into the circuit, the frequency response characteristic of the coupler is set to a constant coupling value over the entire bandwidth. Hereby, the need of calibrating the probe at different frequencies gets dispensable.

In Figure 2 one end section of the test probe TP assembly according to the invention is shown in greater detail. In operation this end is placed next to the microstrip transmission line under test. On one surface of the microstrip PCB board B the coupler arm CA of the passive microstrip line coupler is realized.

Unlike conventional coupler arrangements, the ground G on the back side of the test probe TP is removed partly. As can be seen in Figure 2 the area of removed ground extends beyond the level of the coupler arm CA up to the edge of the test probe. Hence, a sort of spacer (see Figure 2) is created towards the microstrip line under test. As a consequence, the electromagnetic field can propagate to the coupler arm CA at probing angles of 90°.

The shown structure of the input network according to Figure 2 enables consistent measurement results while probing off-centre, with respect to the microstrip line under test, in an angle of 90°.

Unlike the mentioned semi-rigid loop coupler according to the prior art here the physical parameters can be clearly defined, which brings along the advantage of an even smaller possible layout. In addition, the measurement with a thin PCB version of the probe is less error prone than the comparable large semi-rigid design because measurement errors caused by incorrect positioning of the test probe with respect to the microstrip line under test can easily be avoided.

Furthermore, the use of a planar PCB realisation ensures handheld usage, consistent spacer distance and probing angle on the probed circuit under test. Reproducible measurement results can therefore be granted.

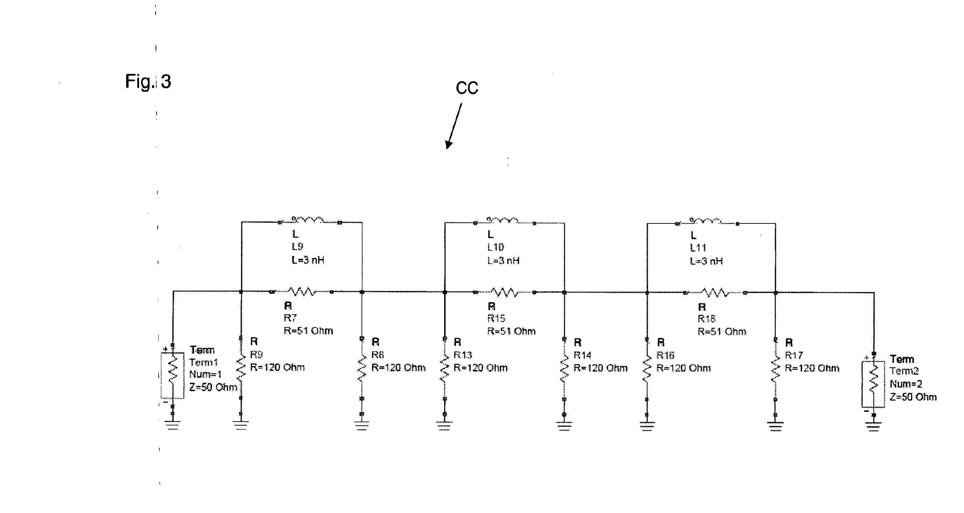

Figure 3 shows a concrete example of the compensation circuit CC of the test probe assembly. By compensating the non-linear frequency response characteristic of the aforementioned input network, coupling behaviour can be set to a constant value. The equaliser as shown in Figure 3 is based on a Pi-attenuator. Each stage of the equaliser consists of three resistors (first stage: R7,R8,R9) and an inductor.

By placing three stages in series, an abrupt frequency response can be achieved. With this low-pass behaviour non-linearities at lower frequencies up to the maximum coupling value are compensated. A high-pass (not illustrated) on the other hand compensates the frequency range from maximum coupling to the poles of the system (at 2 · *fmax*) and therefore once again enlarges the applicable bandwidth.

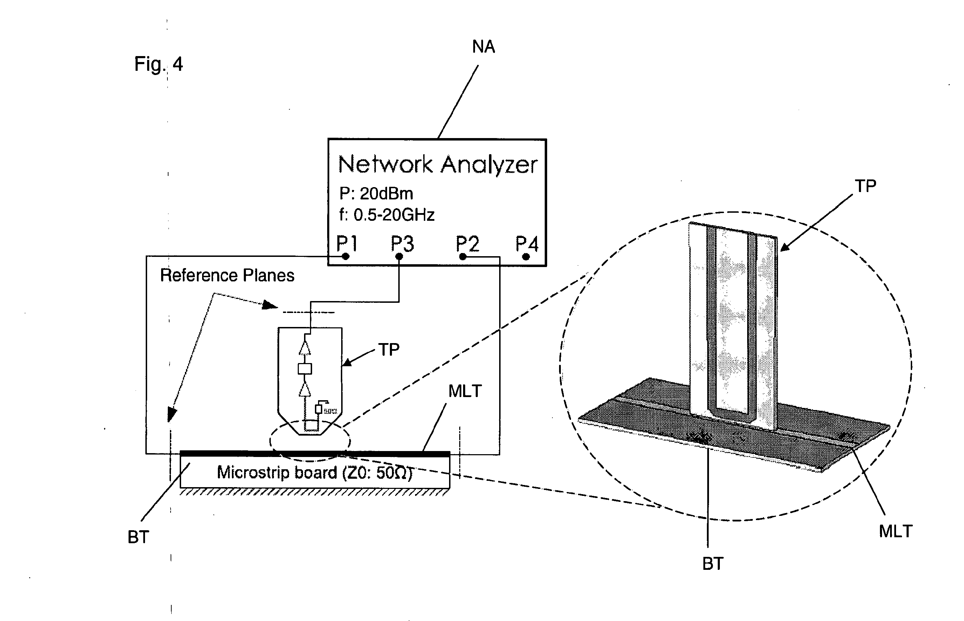

Figure 4 shows a measurement set up of the test probe assembly TP according to the invention (left-hand side of Figure 2). The basic geometrical relations at the one end of the test probe assembly that is next to the microwave transmission line under test MLT is illustrated in the sketch on the right-hand side of Figure 2. The measurement set up consists of the handheld test probe assembly TP, the microwave transmission line under test MLT and a measurement device in the form of a network analyzer NA. Instead of a network analyzer NA a spectrum analyzer or a power meter can be used. Though the use of these alternative measurement instruments would necessitate a change in the overall measurement set up the design and the functioning of the test probe according to the invention would remain unaffected.

The transmission line under test in the form of a microstrip line MLT is realized on a microstrip PCB board BT. The test probe assembly TP is simply used by placing it at an angle alpha of 90° (the angle alpha is defined by the surface plain of the PCB board BT on which the microstrip line under test MLT is realized and the surface plain of the test probe assembly TP itself). Preferably, the lower edge of the test probe assembly TP next to the PCB board BT runs in parallel and above the microstrip line under test MLT.

With the spacer (see Figure 3) in between circuit under test and microstrip coupler arm CA-a defined amount of power is coupled contactlessly to the measurement device NA. As an example, when the probe circuit is realised on a 0.305mm thick microstrip PCB board, positioning errors affect the measurement result only at a minimum for measurements on a 1.1 mm wide 50 Ω microstrip line.

The concept of the handheld test probe assembly according to the invention provides enhanced flexibility in that test measurements can be performed virtually at any point within a circuit under test. In particular possible test points are not limited to prefabricated on-wafer probes.

### References

[1] Yhland, K.; Stenarson, J.: Noncontacting measurement of power in microstrip circuits. In: ARFTG Conference, 2006 67th, 2006, S. 201 - 205.
[2] Yhland, K.; Stenarson, J.; Andersson, K.: A tuneable probe for noncontacting microwave measurements. In: Microwave Conference (EuMC), 2010 European, 2010, S. 775 - 778.
[3] Yhland, K.; Stenarson, J.; Wingqvist, C.: Noncontacting measurement of reflection coefficient and power in planar circuits up to 40 GHz. In: ARFTG Conference, 2007 69th, 2007, S. 1 - 5.

## Claims

1. Handheld test probe assembly (TP) for non-contacting microwave measurements on a microwave transmission line under test (MLT), the test probe assembly (TP) comprising a microstrip line coupler (C) realized on a PCB board (B), with the ground (G) at the back side of the PCB board (B) being removed at an area of the test probe (TP) that in operation is located adjacent to the microwave transmission line under test (MLT).

2. Handheld test probe assembly (TP) according to claim 1, **characterized in that** the area of removed ground (G) extends from the edge of the test probe assembly (TP) located adjacent to the microwave transmission line under test (MLT) at least to the level of the microstrip line coupler (C).

3. Handheld test probe assembly (TP) according to claims 1 or 2, further comprising a compensation network (CC) to which the output signal of the microstrip line coupler (C) is fed, the compensation circuit (CC) being sandwiched between two amplifier stages (A1,A2).

4. Handheld test probe assembly (TP) according to claim 3, **characterized in that** compensation circuit (CC) and the amplifier stages (A1,A2) are realized on the same PCB board as the microstrip line coupler (C).

5. Use of the handheld test probe assembly (TP) according to one of the previous claims for the measurement on a microwave transmission line realized on a PCB board (B), by placing by hand the test probe assembly (TP) adjacent to the microwave transmission line under test (MTL) at an angle of 90° with respect to the surface plane of the PCB board (BT) on which the microwave transmission line under test (MLT) is realized.
